# EUROPEAN PATENT APPLICATION

(11) **EP 4 839 034 A1**
(43) Date of publication of application: **11.11.2026**
(21) Application number: 25174332.4
(22) Date of filing: 05.05.2025
(51) Int. Cl.: H05K 7/20

(54) **A HOUSING ELEMENT FOR A HOUSING FOR AN ELECTRONIC COMPUTING DEVICE, A HOUSING AS WELL AS AN ELECTRONIC COMPUTING DEVICE**

(71) Applicant: Connaught Electronics Ltd., County Galway H54 Y276 (IE)
(72) Inventor: BENLI, Batuhan, Tuam, H54 Y276 (IE)
(74) Representative: Jauregui Urbahn, Kristian

(57) **Abstract**

The present invention relates to a housing element (6) for a housing (5) for an electronic computing device (3) for a motor vehicle (1) comprising at least one cooling fin (10) on an outer side (11) of the housing element (6), wherein that the cooling fin (10) has a waveform in a longitudinal direction of the cooling fin (10). Furthermore, the present invention relates to a housing (5), as well as to an electronic computing device (3).

## Description

The present invention relates to a housing element for a housing for an electronic computing device for a motor vehicle comprising at least one cooling fin on an outer side of the housing element. Furthermore, the present invention relates to a corresponding housing, as well as to a corresponding electronic computing device.

Electronic computing devices, which may also be regarded as so-called electronic units (ECU) are essential components of modern motor vehicles, including advanced driver-assistance systems (ADAS). These system help to enhance vehicle safety and performance by controlling various functions such as braking, steering, and stability control. ECU used in for example ADAS produce heat during operation, which can affect their performance and life span. Cooling is necessary to ensure that the ECU operates within their optimal temperature range, typically between 0 °C and 60 °C. If the temperature exceeds this range, it can cause the ECU to malfunction or even fail, which can have serious safety implications.

In the case of an advanced driver assistance system (ADAS), cooling is particularly important due to the high computational demands of these systems. ADAS typically use multiple sensors such as cameras, radar, and lidar to get a data about the vehicle's surroundings. This data is then processed by the ECU to make decisions about the vehicle's speed, direction, and braking, among other things. The processing of large amounts of data generates a significant amount of heat, which can cause the ECU to overheat if not probably cooled. This can result in decreased performance, reduced accuracy, or even failure of the ADAS system, which can have serious safety consequences.

There are several methods for cooling ECUs in vehicles, including air-cooling, liquid cooling, and thermo-electric cooling. Air-cooling is the most common method and involves using fans to circulate air around the ECU to dissipate heat. Liquid cooling is more efficient than air-cooling and involves circulating a cooling fluid through the ECU to absorb heat and transfer it to a radiator. Thermo-electric cooling uses a solid-state device to convert heat into electricity, which can then be used to cool the ECU.

In conclusion, cooling of ECUs is necessary to ensure their optimal performance and life span, particularly in ADAS, where high computational demands generate significant amounts of heat. Proper cooling methods should be implemented to prevent overheating and ensure safety in motor vehicles.

US 2009 008 069 A1 discloses a tube with a helical fin extending from the tubes outer surface. The fins and tube are monolithic, or formed of one part, with a channel defined between adjacent fins. The fin has a crest with peaks and depressions formed in the crest. The fin peak includes an indent formed in a side surface, and the indent includes a flank and a base surface. The indent flank intersects the fin peak top, and the indent base surface intersects the fin sidewall.

It is an object of the present invention to provide a housing element, a corresponding housing, as well as a corresponding electronic computing device, by which an efficient cooling of the electronic computing device can be realized.

This object is solved by a housing element, a corresponding housing, as well as a corresponding electronic computing device according to the independent claims. Advantageous embodiments are presented in the dependent claims.

One aspect of the invention relates to a housing element for a housing for an electronic computing device for a motor vehicle comprising at least one cooling fin on an outer side of the housing element.

According to an embodiment, the cooling fin has a waveform in a longitudinal direction of the cooling fin.

Therefore, the cooling capacity of the electronic computing device can be enhanced. In particular, the invention proposes to cover the outer side of the housing element, which can be one element from a two-element housing, with fins with in particular so-called knurlings to increase the surface area of the fins.

Cooling fins on Electronic Control Units (ECUs)/electronic computing device serve to dissipate heat generated by the internal components, thereby maintaining optimal operating temperatures. Larger cooling fins, in particular with an enlarged surface, provide an increased surface area for heat exchange between the ECU and the surrounding air.

This results in faster heat dissipation, allowing the unit to operate at safer temperatures. Effective cooling minimizes the risk of thermal throttling, where performance is reduced to control temperature increases, ensuring consistent and optimal performance. The turbulence caused by larger fins creates more frequent collisions between air molecules and the fin surface. This interaction results in better convective heat transfer, which contributes significantly to overall cooling efficiency. By promoting air movement around the fins, these structures help maintain the ECU's temperature stability while also improving its thermal adaptability to different environments. Larger fins act as a buffer against rapid temperature changes due to their increased thermal mass. This means they can absorb heat when temperatures rise and release it slowly during cooling periods, resulting in more stable operating temperatures for the ECU. Such stability reduces stress on internal components, extending their lifespan and ensuring consistent performance over time. In high-temperature or high-altitude environments with thinner air, larger cooling fins offer extra capacity for heat dissipation. This added capacity ensures that the ECU maintains safe operating temperatures even in challenging conditions, improving overall reliability and performance. By effectively managing heat, bigger cooling fins contribute to a longer lifespan for internal components within the ECU. Overheating can significantly shorten the service life of sensitive electronic components; thus, efficient cooling provided by larger fins helps maintain component integrity and functionality over time. Therefore, in particular, larger cooling fins on an ECU play a crucial role in maintaining optimal operating temperatures, improving overall performance and reliability, and extending component lifespan. By providing increased surface area for heat exchange, enhanced airflow, and greater temperature stability, bigger fins ensure that the ECU can withstand various environmental challenges while delivering consistent performance.

Cooling fins are a passive cooling mechanism commonly used in for example aluminum housings for ECU. They work by increasing the surface area of the housing, which allows for more efficient heat dissipation into the surrounding air. The cooling fins are typically made of aluminum or another material with high thermal conductivity. They are attached to the housing element and are arranged in a way that maximizes exposal to the surrounding air. A cooling fin can be straight, serrated, or angled, depending on the design requirements.

When the housing element generates heat during operation, in particular when an electronic component of the ECU generates the heat, the heat is transferred to the cooling fin through conduction. As the air flows over the cooling fin, it absorbs the heat and carries it away from the ECU housing element, which helps to cool the unit down.

In particular, the effectiveness of cooling fins depends on several factors, such as their size, shape, spacing, and orientation. Larger and more closely spaced fins can absorb and dissipate more heat than smaller or more widely spaced fins. Angled fins can also increase the surface area exposed to the airflow, which can further enhance cooling performance. With the invention, the size and therefore the cooling area of at least on cooling fin can be raised, in particular for example about 10 percent. Therefore, the cooling fin is an effective and in particular, also low-cost solution for cooling the ECU. A cooling fin can be used in conjunction with other cooling methods to improve overall thermal performance and insure reliable operation of the electronic computing device.

Therefore, more surface area to cool down the electronic computing device passively, in particular via radiation or heat transfer, is provided. Conventional fin designs according to the state of the art are not capable to cool well the electronic computing devices, if there is not enough space. The invention improves the weak passive cooling methodology of the ECUs in an effective way.

As already mentioned, the housing element is a part of a housing for an electronic computing device. The electronic computing device may be for example in particular configured for performing computation tasks for an advanced driver assistance system (ADAS). The electronic computing device used in the ADAS are a subject to significant thermal stress to their high computational power, rapid data processing requirements, and complex algorithms. Heat generation is a major concern for the ECU designers, as excessive heat can lead to reduced computing capacity, shorter life span, and potential system failures. The amount of heat generated by the ECU depends on various factors such as the type of complexity of the processor, clock speed, memory size, and power consumptions. ADAS electronic computing devices often contain multiple high-performance processors and sensors that generate a significant amount of heat during operation. In addition, electronic computing devices for ADAS are typically located in areas of the motor vehicle where they direct supposed to extreme temperatures, such as the engine compartment or behind the dashboard, which can further exacerbate heat generation and dissipation issues.

Therefore, managing the heat generation in the ECUs for an advanced driver assistance system is critical for ensuring reliability and longevity. Several cooling strategies, in particular including the passive cooling fins and/or active cooling methods, for example heat pipes, liquid cooling and thermal design can be employed to manage heat generation and dissipation in these high-performance ECUs.

According to an embodiment, the housing element comprises at least two cooling fins with a waveform. In particular, also more than two cooling fins can be arranged on the housing element, in particular on an outer side of the housing element. Therefore, the surface for heat dissipation can be increased and therefore a more efficient passive cooling of the electronic computing device can be realized.

In another embodiment, a first waveform of a first cooling fin of the at least two cooling fins corresponds with a second waveform of a second cooling fin of the at least two cooling fins. In particular, the wave valleys of the waveforms and the wave crest of the waveforms are at the same parallel position. In particular, if there are more than two cooling fins, these cooling fins also correspond to each other. Therefore, the spaces between the different cooling fins can be equal over the housing element. This may also minimize the pressure drop across the fin structure, allowing for better airflow and improved heat dissipation. Uniformly-spaced fins further help prevent hotspots by ensuring even heat distribution throughout the ECU housing. This reduces the risk of localized overheating, which could otherwise compromise performance or damage components. A consistent spacing between cooling fins simplifies manufacturing processes and makes quality control more manageable. It also makes maintenance easier as uniform fin geometry ensures that replacement parts are readily available and interchangeable. Therefore, ensuring equal spacing between cooling fins has multiple advantages, including optimized airflow, reduced pressure drop, minimized hotspots, easier manufacturing and maintenance, and improved aesthetics. By implementing consistent fin geometry, you can maximize the heat dissipation potential of your ECU's cooling system. This provides an efficient way of cooling the electronic computing device and also provides an easy generating process of the housing element.

In another embodiment, the at least one cooling fin has a wider basis on the housing than the top of the cooling fin. Therefore, more surface can be generate with an easy form of the at least cooling fin. The broader base helps anchor each fin more securely, reducing the risk of deformation or damage during assembly, handling, or operation. This increased stability enhances durability and ensures that the fins maintain their intended geometry for optimal heat dissipation. The wider basis increases contact area between the cooling fin and the ECU housing, promoting better heat transfer from the unit to the fins. This results in faster and more efficient cooling of internal components, helping to maintain safe operating temperatures. With a broader base, the temperature gradient along the length of each fin is reduced, which helps distribute heat more uniformly. This minimizes hotspots within the ECU, promoting consistent performance and reducing stress on internal components due to extreme temperature variations. The wider basis creates a larger target for incoming airflow, improving convective heat transfer at the fin's base. This can lead to better overall cooling efficiency as more heat is extracted from the ECU housing and dissipated into the surrounding environment. Fins with wider basis are easier to manufacture and install securely, which simplifies production processes and reduces manufacturing costs. Additionally, this design can improve yield rates and decrease the likelihood of damage during assembly or handling. Therefore, an ECU cooling fin with a wider basis offers increased stability, improved heat transfer at the base, reduced thermal gradient, enhanced airflow around the base, and better manufacturability. By implementing this design, you can optimize your ECU's cooling performance while enhancing its durability and reliability.

According to another embodiment, the at least cooling fin and the housing element are formed with the same material. Therefore, the at least one cooling fin and the housing element is in particular a so-called monolithic component which means, that they are made of a single, solid piece of unit, without any significant internal divisions or subcomponents. Therefore, an efficient heat dissipation, with no heat peaks can be generated.

In another embodiment, the at least one cooling fin and the housing element are formed out of aluminum or an aluminum alloy. Aluminum is an advantaged choice for housings of electronic control units to the several advantages. Aluminum is a lightweight material, which makes it an ideal choice for ECU housings where weight is a critical factor. This is especially important in automotive and aerospace applications reducing the overall weight of the system can lead to significant feel savings and improve performance. Aluminum has further an excellent thermal conductivity, which makes it an ideal material for housings that need to dissipate heat generated by the internal components. By providing a pathway for heat to escape, aluminum can help prevent overheating and prolong the life of the electronic computing device. Aluminum is a highly durable material that can resist in harsh environments and resist corrosion, making it ideal choice for housings that are subjected to moisture, dust, or other contaminants. It is high strength-to-weight ratio also makes it resistant to impact and vibration, further enhancing its durability. Aluminum is further relatively inexpensive material compared to alternative such as titanium or stainless steel. It can be easily machined, formed, and welded, which reduces manufacturing costs and manufacturing effort and lead times. It is easy work on and also be customized to match the specific conditions of the surrounding components or enclosure. In particular, aluminum offers an excellent combination of lightweight, thermal conductivity, durability, cost-effectiveness, making the aluminum a popular choice for the housings in particular the environment of a motor vehicle.

In another embodiment, the waveform comprises a triangular shape with a linear pattern. In particular, the triangular shape has been applied onto the surfaces with the linear pattern. The whole fin surfaces are therefore covered to increase the surface area as much as possible. The triangles are aligned in parallel to the mold. In particular, the cooling fin is configured as a so-called knurling. Knurlings refer to a pattern of parallel, linear, or diamond-shaped patterns or ridges that are machined or pressed onto the surface of a material, typically metal, in particular aluminum. The process of creating knurls is called knurling and involves using a specialized tool, such as knurling wheel or knurling tool, to create the pattern on the surface. Knurls serve as several purposes in engineering applications. There are several types of knurling patterns, including straight line, cross line, diamond, and helical. The choice of pattern depends on the intended use, material properties, and surface finish requirements. In particular, knurls are a machine technique used to create a textured pattern on the surface of the cooling fins. They improve the surface area and therefore can improve the heat dissipation of the housing element.

According to another embodiment, an edge of the triangular shape is rounded. In particular, sharp edges of the triangles have to be rounded due to production capability of the mode. Rounding the edges of a triangular-shaped cooling fin offers several advantages for ECU cooling systems. Sharp corners and edges can act as stress concentrators in metal structures, making them more susceptible to deformation or fracture under load. Rounded edges distribute loads more evenly, reducing the risk of damage from mechanical stress or vibration. The rounded edges of a triangular fin allow for smoother airflow around the fin's corners, reducing turbulence and improving convective heat transfer. This can lead to more efficient cooling performance compared to fins with sharp edges. Rounded edges are safer and less likely to cause injury during handling or assembly. Additionally, they reduce the risk of damage from impact or abrasion in transport or operation. Rounding the edges of triangular fins can simplify the manufacturing process by reducing the risk of burrs or sharp edges that may require additional finishing operations. This can help decrease production costs and improve efficiency. Therefore, rounding the edges of a triangular-shaped cooling fin provides benefits such as reduced stress concentration, improved airflow, and decreased risk of injury, enhanced aesthetics, and easier manufacturing. By implementing this design, the ECU's cooling performance is optimized while improving its durability, safety, and manufacturability.

In another embodiment, the housing element is a molted component. Molded housings for the electronic computing device has several. Molded housings are providing a high level of protection for the electronic computing device components from environmental factors such as moisture, dust, vibration, and impact. The molded housing can be designed with specific features such as seals, gaskets and ledges to ensure a tight seal and prevent contamination from entering the enclosure. Molded housings are highly durable and resistant to corrosion, making them ideal for use in harsh environments where exposure to moisture, chemicals, or other contaminants is common. The housing can also withstand high levels of vibration and impact without cracking or breaking. Molded housings can be custom-designed to fit the specific needs for the components of the electronic computing device and the application in which it is used. This includes designing features such as mounting points, connectors, and access panels, as well as cooling fins, to make installation and maintenance easier. Molded housings can also be designed with a variety of colors, textures, and finishes to match the conditions of the surrounding components or enclosure. Furthermore, molded housings can be produced in large qualities than other types of enclosures, such as machined or fabricated metal enclosures. The injection molding process allows for a high precision and repeatability, reducing the need for additional finishing processes. Molded housings can also be designed with specific features to manage the thermal dissipation, including vents, heat sinks, and cooling channels, as well as the cooling fins. This helps to ensure that the components of the electronic computing device remain within their operating temperature range, prolonging the life span and improving performance. In particular, molded housings offer a high level of protection, durability, customization, and thermal management, making it an ideal choice for many different ECU applications.

Another aspect of the invention relates to a housing for an electronic computing device for a motor vehicle with at least one housing element according to the preceding aspect, and with one further housing element. In particular, between the first housing element and the further housing element an interior is provided, wherein in the interior electronic components of the electronic computing device can be arranged.

According to an embodiment of the housing, the further housing element is configured as a housing element according to the preceding aspect. Therefore, the two housing elements can be provided with the cooling fins according to the preceding aspect. Therefore, an improved cooling of the electronic computing device can be provided.

Another aspect of the invention relates to an electronic computing device comprising at least one electronic component and one housing according to the preceding aspect. The electronic component in particular generates heat during an operation of the electronic component. The heat can be dissipated to the housing and therefore a passive cooling of the electronic component can be provided.

According to an embodiment of the electronic computing device, the at least one electronic component is arranged in an interior of the housing. Therefore, the electronic component can be protected from environmental influence. Furthermore, the heat of the electronic component can be transferred from the interior, in particular from the inside, of the housing to the housing element.

According to another embodiment of the electronic computing device, the electronic computing device is configured for an at least in part automated operation of the motor vehicle. In particular, the electronic computing device can be an electronic computing device of a so-called advanced driver assistance system (ADAS). Furthermore, the electronic computing device can be used for a fully automatic operation of the motor vehicle.

Therefore, another aspect of the invention relates to a motor vehicle comprising at least the electronic computing device according to the preceding aspect. Furthermore, the motor vehicle may comprise at least an assistance system comprising the electronic computing device or an automated driving system comprising at least the electronic computing device.

Advantageous embodiments of the housing element are to be regarded as advantageous embodiments of the housing, the electronic computing device, as well as the motor vehicle.

In particular, a computing unit/electronic computing device can include one or more computers, one or more microcontrollers and/or one or more integrated circuits, for example one or more application-specific integrated circuits, ASIC, one or more field-programmable gate arrays, FPGA, and/or one or more systems on a chip, SoC. The computing unit can also include one or more processors, for example one or more microprocessors, one or more central processing units, CPU, one or more graphics processing units, GPU, and/or one or more signal processors, in particular one or more digital signal processors, DSP. The computing unit can also include a physical or virtual cluster of computers or others of the mentioned units.

A computing unit/electronic computing device can also include one or more hardware and/or software interfaces and/or one or more storage units. Therein, a storage unit can be designed as a volatile data memory, for example as a dynamic random access memory, DRAM, or static random access memory, SRAM, or as a non-volatile data memory, for example as a read-only memory, ROM, as a programmable read-only memory, PROM, as an erasable programmable read-only memory, EPROM, as an electrically erasable programmable read-only memory, EEPROM, as a flash memory or flash EEPROM, as a ferroelectric random access memory, FRAM, as a magnetoresistive random access memory, MRAM, or as a phase-change random access memory, PCRAM.

Advanced Driver-Assistance Systems (ADAS) according to this invention are sophisticated electronic systems designed to enhance vehicle safety and driver convenience. These systems consist of various technical components, including sensors, cameras, radar, lidar, actuators, and control units. Sensors play a crucial role in detecting the environment around the vehicle. They include ultrasonic sensors, cameras, radar, and lidar. Ultrasonic sensors use sound waves to measure distances to nearby objects, while cameras capture images of the road and surrounding area. Radar and lidar use radio or light waves, respectively, to detect objects at longer ranges and with higher precision. ADAS control units/electronic computing device process sensor data and make decisions based on that information. They typically consist of a microcontroller, memory, input/output interfaces, and communication protocols. The control unit receives data from the sensors, processes it using algorithms and machine learning techniques, and then sends commands to the actuators to take appropriate actions. Actuators are devices that convert electrical signals into physical movements or actions. They include electric motors, solenoids, and hydraulic or pneumatic systems. For example, an electric motor can adjust the steering angle, while a solenoid can control the brakes or throttle position. A user interface provides feedback to the driver about the status of the ADAS. It includes visual displays, audible alerts, and haptic feedback. Visual displays show information on dashboard screens, while audible alerts use sounds or voice messages to warn the driver of potential hazards. Haptic feedback can include steering wheel vibrations or seat pulses to alert the driver of danger. ADAS rely on communication protocols to transmit data between components. Common protocols include CAN (Controller Area Network), LIN (Local Interconnect Network), and Ethernet. These protocols allow different components to communicate with each other, ensuring that the ADAS functions as intended. Modern ADAS use machine learning algorithms to improve their performance over time. These algorithms analyze sensor data and learn from it, allowing the system to adapt to changing conditions and improve its accuracy. In summary, an ADAS consists of various technical components, including sensors, control units, actuators, user interfaces, communication protocols, and machine learning algorithms. By combining these elements, ADAS can help improve vehicle safety, reduce accidents, and enhance the driving experience.

Further features of the invention are apparent from the claims, the figures and the description of figures. The features and feature combinations mentioned above in the description as well as the features and feature combinations mentioned below in the description of figures and/or shown in the figures can be encompassed by the invention not only in the respectively specified combination, but also in other combinations. In particular, implementations and feature combinations can also be encompassed by the invention, which do not comprise all of the features of an originally formulated claim. Moreover, implementations and feature combinations can be encompassed by the invention, which extend beyond or deviate from the feature combinations set forth in the relations of the claims.

Therefore, the figures show in:
- Fig. 1: a schematic side view according to an embodiment of a motor vehicle comprising an embodiment of an assistance system comprising an embodiment of an electronic computing device;
- Fig. 2: a schematic side view according to an embodiment of an electronic computing device comprising an embodiment of a housing comprising an embodiment of a housing element;
- Fig. 3: a schematic perspective view according to an embodiment of a housing element;
- Fig. 4: another schematic perspective view according to an embodiment of a housing element;
- Fig. 5: an enlarged view according to an embodiment of a housing element; and
- Fig. 6: a schematic side view according to an embodiment of an housing element.

In the figures, the same elements are presented with the same reference signs.

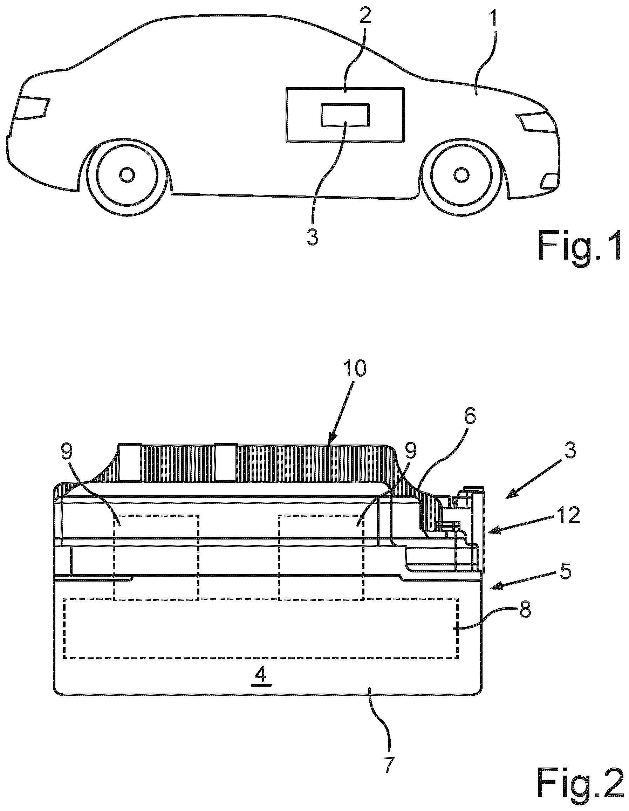

Fig. 1 shows a schematic side view according to an embodiment of a motor vehicle 1. The motor vehicle 1 may be configured as an at least in part automated motor vehicle 1 or a fully automated motor vehicle 1. Therefore, the motor vehicle 1 may comprise at least one assistance system 2. The assistance system 2 may comprise at least one electronic computing device 3, wherein the electronic computing device 3 is configured for computing tasks of the assistance system 2. For example, the electronic computing device 3 can be configured for computing sensor information from capturing devices of the motor vehicle 1.

Fig. 2 shows a schematic side view according to an embodiment of an electronic computing device 3. The electronic computing device 3 according to the shown embodiment has an interior 4. The interior 4 is in particular formed by a housing 5. The housing 5 according to the shown embodiment comprises at least a first housing element 6 as well as a second housing element 7. In the interior 4 a printed circuit board 8 as well as two electronic components 9 are shown. The electronic components 9 may generate heat during an operation of the electronic components 9.

According to the shown embodiment, the first housing element 6 may comprise a plurality of cooling fins 10. On the other hand, the second housing element 7 do not comprise any cooling fins 10. This is just an embodiment, because the second housing element 7 may also comprise cooling structures, for example cooling fins 10, as shown with the first housing element 6.

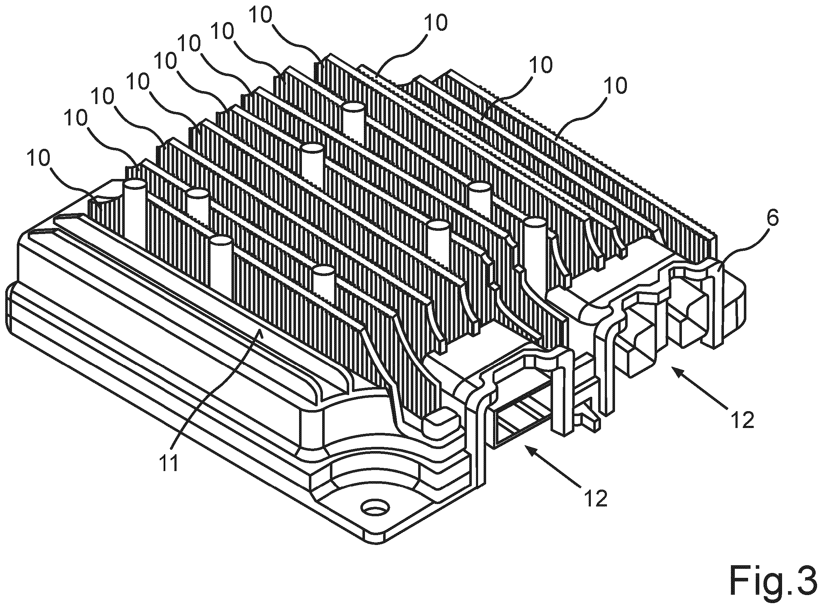

Fig. 3 shows a schematic perspective view according to an embodiment of a housing element, in particular of the first housing element 6. Fig. 3 shows, that a plurality of cooling fins 10 are arranged on an outer side 11 of the first housing element 6. In particular, as shown in Fig. 3, the cooling fin 10 has a waveform in a longitudinal direction of the cooling fin 10. As shown, the housing element 6 comprises at least two cooling fins 10 with a waveform. The at least two cooling fins 10 are arranged essentially in parallel to each other.

Furthermore, the at least cooling fin 10 and the housing element 6 are formed with the same material, for example, the cooling fins 10 as well as the housing element 6 may be formed from aluminum or an aluminum alloy. Furthermore, the housing element 6 is in particular a so-called molded component.

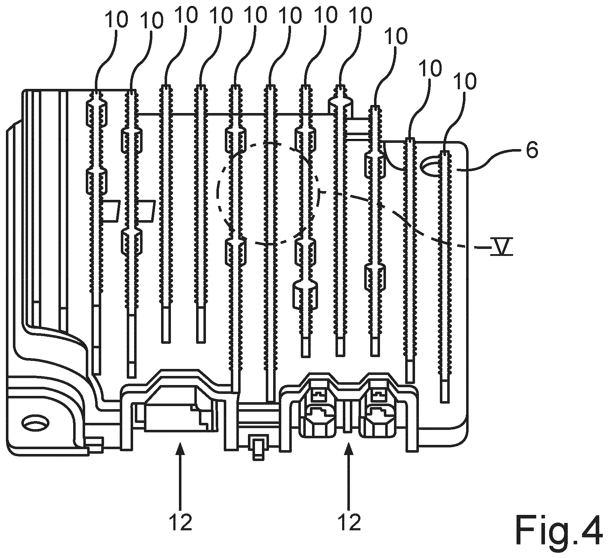

Fig. 4 shows another schematic perspective view according to the housing element 6 shown in Fig. 3. In particular, Fig. 4 shows a socket 12 as well as the cooling fins 10.

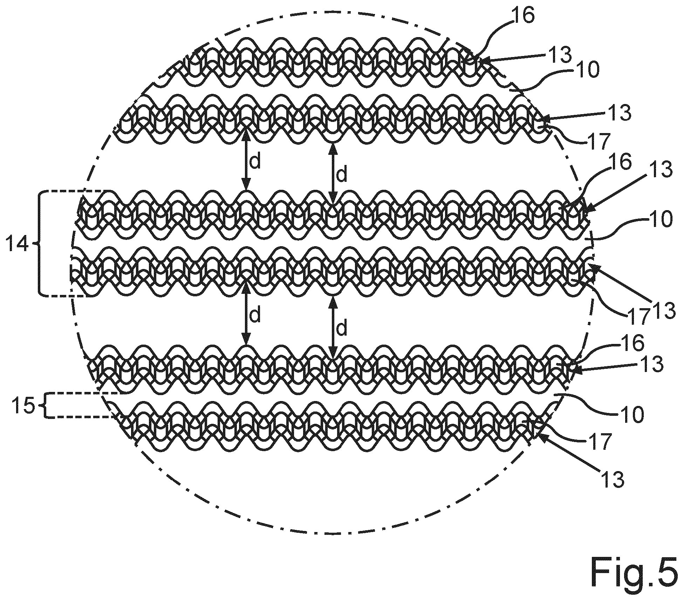

Fig. 5 shows a schematic enlarged view according to an embodiment of the housing element 6, in particular an enlarged view of the cooling fins 10. In particular, the Fig. 5 shows that the waveform comprises a triangular shape 13. Furthermore, Fig. 5 shows that a base of at least one cooling fin 10 is wider than a top 15 of the cooling fin 10. Furthermore, it is shown, that the cooling fins 10 have a predefined distance d to each other. Furthermore it is shown, that the edge of the triangular shape 13 is rounded.

Therefore, Fig. 5 shows the triangular shape that has been generated on the fin surfaces with the linear pattern. The whole fin surfaces are covered to increase the surface area as much as possible. The triangles have to align in parallel to the mold access due to the mold of the heat sink from the die-cast.

The triangular shape pattern has to be shifted to keep the distance d to the same between two cooling fins 10. The surface of the triangle has to be tilted respecting the main tool access to demold from the tool. Sharp edges of the triangles have to be rounded due to production capability of mold.

Furthermore, Fig. 5 shows that a first waveform 16 of a first cooling fin 10 of the at least two cooling fins 10 corresponds with a second waveform 17 of a second cooling fin 10 of the at least two cooling fins 10.

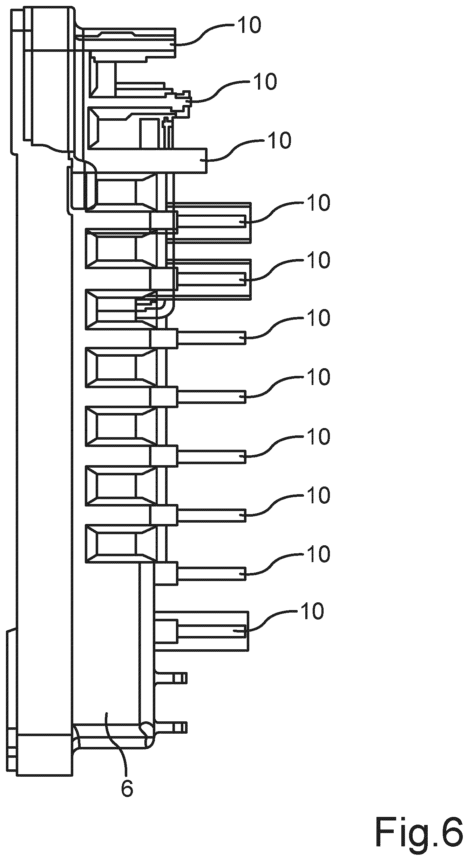

Fig. 6 shows a schematic side view according to an embodiment of the housing element 6. In particular, the plurality of cooling fins 10 are shown in the side perspective.

## Claims

1. A housing element (6) for a housing (5) for an electronic computing device (3) for a motor vehicle (1) comprising at least one cooling fin (10) on an outer side (11) of the housing element (6),
**characterized in that**
the cooling fin (10) has a waveform in a longitudinal direction of the cooling fin (10).

2. The housing element (6) according to claim 1,
**characterized in that**
the housing element (6) comprises at least two cooling fins (10) with a waveform.

3. The housing element (6) according to claim 2,
**characterized in that**
the at least two cooling fins (10) are arranged essentially in parallel to each other.

4. The housing element (6) according to claim 3,
**characterized in that**
a first waveform (16) of a first cooling fin (10) of the at least two cooling fins (10) corresponds with a second waveform (17) of a second cooling fin (10) of the at least two cooling fins (10).

5. The housing element (6) according to any one of claims 1 to 4,
**characterized in that**
the at least one cooling fin (10) has a wider basis (14) on the housing element (6) than a top (15) of the cooling fin (10).

6. The housing element (6) according to any one of claims 1 to 5,
**characterized in that**
the at least one cooling fin (10) and the housing element (6) are formed with the same material.

7. The housing element (6) according to claim 6,
**characterized in that**
the at least one cooling fin (10) and the housing element (6) are formed out of aluminum or an aluminum alloy.

8. The housing element (6) according to any one of claims 1 to 7,
**characterized in that**
the waveform comprises a triangular shape (13) with a linear pattern.

9. The housing element (6) according to claim 8,
**characterized in that**
an edge of the triangular shape (13) is rounded.

10. The housing element (6) according to any one of claims 1 to 9,
**characterized in that**
the housing element (6) is a molded component.

11. A housing (5) for an electronic computing device (3) for a motor vehicle (1) with at least one housing element (6) according to any one of claims 1 to 10 and at least one further housing element (7).

12. The housing (5) according to claim 11,
**characterized in that**,
the further housing element (7) is configured as a housing element (6) according to any one of claims 1 to 10.

13. An electronic computing device (3) comprising at least one electronic component (9) and one housing (5) according to claim 11 or 12.

14. The electronic computing device (3) according to claim 13,
**characterized in that**
the at least one electronic component (9) is arranged in an interior (4) of the housing (5).

15. The electronic computing device (3) according to claim 13 or 14,
**characterized in that**
the electronic computing device (3) is configured for an at least in part automated operation of the motor vehicle (1).
